# EUROPEAN PATENT APPLICATION

(11) **EP 2 568 794 A2**
(43) Date of publication of application: **13.03.2013**
(21) Application number: 12183298.4
(22) Date of filing: 06.09.2012
(51) Int. Cl.: H05K 7/20

(54) **Control system for controlling a cooling performance**

(30) Priority: 06.09.2011 DE 202011105395 U
(71) Applicant: Knürr GmbH, 94424 Arnstorf (DE)
(72) Inventor: Ebermann, Heiko, 01109 Dresden (DE); Trepte, Wolfgang, 01665 Zehren (DE); Koch, Peter, 86946 Vilgertshofen (DE)
(74) Representative: Heim, Florian Andreas

(57) **Abstract**

The invention refers to a control system for controlling the cooling performance of a cooling system in a cabinet adapted for the accommodation of electrical and electronic devices, wherein said cooling system comprises an air/fluid heat exchanger for cooling the air heated in the cabinet by said electrical and/or electronic devices, an inflow duct for routing a cooling fluid to the air/fluid heat exchanger, a return duct for routing heated cooling fluid away from said air/fluid heat exchanger, and a flow restrictor for adjusting the rate of flow of said cooling fluid, wherein said control system comprises a control and evaluation system for the purpose of adjusting said flow restrictor. Further, a temperature detector for detecting the temperature of the cooling fluid is provided in said outflow duct and said control and evaluation system is adapted to adjust said flow restrictor in accordance with the temperature of the cooling fluid as detected by said temperature detector, for the purpose of controlling the rate of flow of said cooling fluid. Additionally, the invention refers to a cabinet comprising this control system.

## Description

The present invention relates, in a first aspect, to a control system for controlling the cooling performance of a cooling unit in a cabinet adapted for the accommodation of electrical and electronic devices, as defined in the generic clause of claim 1.

In further aspects, the invention relates to a cooling system as defined in the generic clause of claim 13 and a cabinet adapted for the accommodation of electrical and electronic devices, as defined in the generic clause of claim 14.

In a known control system for controlling the cooling performance of a cooling unit in a cabinet adapted for the accommodation of electrical and electronic devices, in which the cooling unit comprises an air/fluid heat exchanger for cooling the air heated by the electrical and/or electronic devices present in the cabinet, an inflow duct for routing a cooling fluid to the air/fluid heat exchanger, an outflow duct for routing the heated cooling fluid away from the air/fluid heat exchanger, and a flow restrictor for the purpose of adjusting the rate of flow of the cooling fluid, the control system comprises a control and evaluation system for the purpose of adjusting the flow restrictor.

A generic cooling system for a cabinet adapted for the accommodation of electrical and electronic devices comprises a cooling unit comprising an air/fluid heat exchanger for cooling the air heated by electrical and/or electronic devices present in the cabinet, an inflow duct for routing a cooling fluid to the air/fluid heat exchanger, an outflow duct for routing the heated cooling fluid away from the air/fluid heat exchanger, and a flow restrictor for the purpose of adjusting a rate of flow of the cooling fluid.

Such a cooling system is disclosed, for example, in DE 10 2007 061 966 B4. In this case, the cooling performance can be adjusted by means of a current of air, for which purpose flow control valves are provided that are accessible to a user.

For example, one field of application of such cooling systems is server farms, in which a plurality of cabinets adapted for the accommodation of electrical and electronic devices is arranged in rows. A cold aisle, to which cooled air is fed, is formed on one side of the row of cabinets. The cooled air is routed into the cabinets and used in this case for the purpose of cooling the electrical and electronic devices. The air heated during this process is discharged on the opposite side of the cabinet into a hot aisle. However, the air in the hot aisle must not have an unduly high temperature. Use can therefore be made of the control systems and cooling systems described above for cooling the air discharged or to be discharged from the cabinet.

In an alternative field of application, the cooling system is used for cooling the air in the cabinet in order to cool the electrical and electronic devices in this manner. In this case, the cabinet can be substantially airtight for the purpose of forming a closed circuit of air within the cabinet.

A basic aim of generic control systems and cooling systems is to adapt the rate of flow of the cooling fluid to a required cooling performance. This cooling performance is implemented for the purpose of cooling the air of an environment. The air thus cooled can then be discharged, for example, into a hot aisle of a server center. In an alternative arrangement, it is possible to cool electrical and electronic devices such as servers in an equipment cabinet by means of the cooled air.

In conventional control systems and cooling systems, the cooling performance is adjusted in accordance with an air temperature. In this case, the air is usually the ambient air or the server cooling air. When the air temperature rises, the rate of flow of the cooling fluid in the cooling system is increased.

In the prior art, the control systems for controlling the cooling performance of a cooling unit are equipped with electrical or hydraulic drives. These require electrical energy, which can also be referred to as auxiliary energy, for the reference signal, namely the measured air temperature, and for the supply of energy to the drive system.

One disadvantage arising from the use of an air temperature as the reference variable is the necessity to mount a temperature sensor, or usually a number of temperature sensors, at the sites relevant to the measurement of temperature. If the temperature sensor is mounted at an unsuitable site, the temperature of the devices to be cooled is adjusted to an unduly high or unduly low value. This problem is intensified in systems in which the site relevant to temperature measurement is non-stationary. This may particularly be the case in cooling systems that have a large flow exit area or that are in dynamic interaction with each other. It is then hardly possible to ascertain the actual cooling requirements by means of a stationarily mounted temperature sensor. If the temperature is adjusted to an unduly high value, it has a detrimental effect on the service life of the devices to be cooled. An unduly low temperature gives rise to an unnecessary expenditure of energy and may additionally lead to the development of condensation.

A further disadvantage of known control systems and cooling systems is the high electrotechnical expenditure involved. Auxiliary energy has to be supplied, the control systems have to be integrated in the overall control array, and the temperatures determined at various points of measurement have to be adequately considered, that is to say, have to be linked logically. This involves higher costs and additional expenditure of time for the installation of the temperature sensors.

It may be regarded as being an **object** of the invention to provide a control system, a cooling system, and a cabinet adapted for the accommodation of electrical and electronic devices, in which a rate of flow of a cooling fluid can be controlled in accordance with a required cooling performance in a particularly simple, reliable, and cost-effective manner.

This object is achieved by the control system having the features defined in claim 1, the cooling system having the features defined in claim 13, and the cabinet adapted for the accommodation of electrical and electronic devices having the features defined in claim 14.

Preferred embodiments of the invention are the subject-matter of the dependent claims and are further explained in the following description, more particularly with reference to the figures.

In the control system of the above type, a temperature detector is provided, according to the invention, for the purpose of detecting the temperature of the cooling fluid in the outflow duct, and the control and evaluation system is adapted to adjust the flow restrictor in accordance with the temperature of the cooling fluid as detected by the temperature detector, for the purpose of controlling the rate of flow of the cooling fluid.

It may be regarded as being a central concept of the invention to control the rate of flow of the cooling fluid and thus the cooling energy or cooling performance applied in accordance with the temperature of the cooling fluid. Thus it is not necessary to measure the air temperature in an environment to be cooled. It is advantageously not necessary to measure the air at selected points using logically linked air temperature sensors.

The invention is based on the realization that as the temperature of the environment to be cooled rises, the temperature of the cooling fluid is also caused to rise increasingly by said environment. Therefore, the temperature of the cooling fluid can be implemented as a measure of the ambient temperature. In order to keep the temperature of the environment to be cooled within a desired temperature range, the cooling performance is adjusted, according to the invention, by means of the rate of flow of the cooling fluid. The flow restrictor can be adjusted for this purpose. The rate of flow can be varied by means of the flow restrictor, particularly continuously or in steps, so as to range between a maximum and a minimum value.

The temperature detector can be mounted in or on the cooling fluid return duct and it can basically be of any desired type. When the temperature detector registers an increased temperature of the cooling fluid in the return duct, it may be concluded that there is an increased temperature of the environment to be cooled. Therefore, the control and evaluation system then adjusts the flow restrictor such that the cooling fluid flows to the air/fluid heat exchanger at a higher rate. By contrast, when the temperature of the cooling fluid drops, the rate of flow can be reduced by means of the flow restrictor.

In a preferred embodiment of the control system of the invention, the flow restrictor may be disposed in or on the inflow duct. By contrast, in an alternative preferred embodiment of the control system of the invention, the flow restrictor is disposed in or on the return duct. In both cases, the rate of flow can be readily regulated.

In principle, the flow restrictor can be driven by means of auxiliary energy. This is particularly preferred in the case of high rates of flow. However, the flow restrictor and/or the control system can, in a cost-effective embodiment of the invention, operate without the use of auxiliary energy.

In this case, the flow restrictor can be configured so as to alter its position or shape directly in accordance with the temperature of the cooling fluid. To this end, it can comprise at least one component that experiences a thermally induced or defined change in length when there is a change in temperature of the cooling fluid. In this preferred exemplary embodiment of the control system of the invention, the temperature detector is formed, at least in part, by the flow restrictor. Thus it is advantageously possible to set up a control system that operates without the use of auxiliary energy. In addition, the expenditure of the installation can be reduced.

In a preferred embodiment of the control system of the invention, the temperature detector, the flow restrictor, and the control and evaluation system are formed, at least in part, by a valve adapted to achieve temperature-dependent control of a rate of flow of the cooling fluid, which valve comprises a valve gap through which the cooling fluid flows, a shut-off member, the position of which adjusts the flow of the cooling fluid through the valve gap, and an actuator for controlling the position of the shut-off member. The actuator exhibits a thermally defined change in length for the purpose of controlling the position of the shut-off member and is disposed in a region through which the cooling fluid flows, at least in part.

Thus the temperature-dependent control process is carried out by an actuator that displaces itself in accordance with its temperature or the temperature of the cooling fluid flowing around it. In this way, the actuator advantageously need not necessarily be supplied with energy from an external source. The actuator is disposed such that it comes into contact, or is in contact, with the cooling fluid flowing through during operation of the valve and thus substantially takes on the temperature of the cooling fluid. A change in temperature of the cooling fluid results in a change in length of the actuator. As a result, the actuator applies pressure or traction to the shut-off member and thus adjusts its position relative to the valve gap.

There is advantageously no need to install an electrical system which may comprise a plurality of temperature sensors on the electrical and electronic devices, circuits for evaluating the temperatures measured, and motors for actuating the valves.

For the purposes of the invention, the term "rate of flow of the cooling fluid" is to be understood to mean the volumetric rate of flow, that is, in terms of volume per unit of time, or, also, the mass flow.

The cooling fluid can be an arbitrary liquid or an arbitrary gas. Preferably, the cooling fluid is water. The cooling fluid may be chilled, which, although not basically necessary, does increase the cooling performance of the heat exchanger however.

The term "thermally induced or defined change in length of the actuator" can be understood to mean that the length of the actuator is temperature-dependent. In this connection, it is possible to implement the change in length of the actuator such that the actuator moves the shut-off member towards an open position as the temperature rises, at least within a defined temperature range, such that the rate of flow is increased. When the temperature drops, the shut-off member is moved towards a closed position, at which the rate of flow of the cooling fluid through the valve gap is reduced.

The shut-off member can be a valve cone, which, in a closed position, can completely close the valve gap formed between said cone and a valve seat.

In a preferred embodiment of the invention, the flow restrictor or the actuator is an expansible element. The latter can comprise a housing filled with an expandable material such as wax, paraffin wax, or oil. The volume of the expandable material can be temperature-dependent. A change in volume of the expansible element can be converted via its housing to a change in length of the expansible element. Preferably, the expansible element is disposed such that it changes in length along an imaginary line drawn between the shut-off member and the valve gap. For this purpose, the expansible element can be configured so as to be elastic in the direction of the shut-off member, for example, by means of a membrane or an elastomer insert.

In an advantageous variant of the control system of the invention, there takes place a continuous change in the position of the shut-off member as a result of the change in length of the actuator. Consequently, the rate of flow of the cooling fluid varies continuously and can be of an arbitrary value ranging between a maximum and a minimum value. The minimum rate of flow can, if desired, be zero, for example, when the valve gap of the valve is closed.

The following embodiment of the valve of the invention is advantageous, in order, in particular, to achieve a defined position of the shut-off member. In this embodiment there is provided a spring that applies force to the shut-off member in the closing direction towards the valve gap. The spring, which may also be regarded as a return spring, achieves a defined position of the shut-off member whenever the expansible element contracts. The force applied by the spring can result in a pushing or pulling action in the direction of the movement capability of the spring. Preferably, the spring and the actuator are disposed on opposite sides of the shut-off member.

In a further preferred exemplary embodiment of the control system of the invention, an adjusting device is provided, more particularly one comprising a screw-threaded rod, for the purpose of adjusting the position of the shut-off member. By means of such an adjusting device, a user can set a desired rate of flow for a currently given temperature manually or by means of a remotely controlled motor. It is alternatively possible for the adjusting device to adjust the distance between the actuator and the valve gap or the shut-off member. By varying this distance, it is possible to adjust the change in length as required for causing the actuator to initiate the process of pressing the shut-off member towards the valve gap. That is, it is possible to set a threshold temperature at which the control action starts. Alternatively, provision may also be made for the position of the spring to be variable by means of the adjusting device. Thus a desired temperature of the cooling fluid and, consequently, the cooling performance can be varied by means of the adjusting device.

A preferred variant of the control system of the invention is characterized in that the valve gap is substantially impassable in a closed position of the shut-off member and unobstructed in an opened position thereof, and the actuator is designed such that a change in length of the actuator, as a result of which the shut-off member is moved between its closed position and its opened position, takes place within a temperature range of less than 10°C, preferably less than 6°C, and very preferably less than 3°C. In this case, an expandable material, or a coefficient of expansion of the actuator, is selected such that it is suitable for effecting the desired change in length. A comparatively precise temperature threshold is advantageously provided by the use of a relatively small temperature range. Within the temperature range above and below the threshold, the rate of flow and thus the cooling performance will vary between a very low and a very high value. This may be regarded as a jump in the level of the rate of flow.

The material of which the expandable material is composed can be selected such that it undergoes a phase transition within the desired temperature range. As a result, a particularly large change in length is possible at a well-defined temperature threshold.

Alternatively or additionally, provision may also be made for the change in length of the actuator to be substantially linearly dependent on the temperature at least over a defined temperature range. The rate of flow can thus advantageously vary continuously between a low and a high value. The temperature range can be, for example, a range of 20°C, which can lie between 0°C and 60°C. The change in length can also be approximately proportional to the square or the square root of a temperature change instead of being linearly dependent on the temperature. To this end, the actuator can comprise various expandable materials that undergo phase transitions, in particular, at various temperatures.

A preferred variant of the invention is characterized in that the control system operates without the use of auxiliary energy. By virtue of the fact that the actuator itself detects the temperature to be controlled, the valve need not be supplied with energy for the purpose of transmitting a temperature signal. Furthermore, the movement of the actuator is effected by the temperature of the cooling fluid so that it is also not necessary to supply external energy for this purpose. The advantage gained is that the design is simplified considerably as a result.

In a particularly preferred design variant of the control system of the invention, the actuator is disposed downstream of the valve gap. When the actuator expands due to an increased temperature of the cooling fluid, the actuator then presses the shut-off member against the dynamic pressure of the cooling fluid.

In principle, provision may be made for the actuator to be freely movable relatively to the shut-off member. In this case, the actuator can only press against the shut-off member, but cannot pull the same. A return spring and/or the dynamic pressure of the cooling fluid can then be implemented to achieve a return movement of the shut-off member.

Preferably, however, the actuator is connected to the shut-off member. As a result, the shut-off member can be moved by the actuator in the direction of the valve gap and in the opposite direction. The actuator and the shut-off member can alternatively be in the form of a single device, of which the length is temperature-dependent and which can thus control the rate of flow of fluid passing through the valve gap.

In a cooling system of the above type, a control system, as described above is provided, according to the invention. In the embodiments in which the control system comprises a valve for the temperature-dependent control of a rate of flow of a cooling fluid, the valve is disposed in the outflow duct. In this case, the valve can control the rate of flow of the cooling fluid through the air/fluid heat exchanger. By virtue of the fact that the valve is disposed downstream of the air/fluid heat exchanger, the control variable of the valve is the temperature of the heated cooling fluid. This fluid was heated in the air/fluid heat exchanger and thus by the ambient air. Thus the heating of the cooling fluid is dependent on the temperature of the air to be cooled or the devices to be cooled in the cabinet. As a result, a substantially constant air temperature is achieved in the cabinet by means of the control process proposed by the invention. There is advantageously no need to measure the air temperature in the cabinet for this purpose. Thus the control process does no longer depend on the selection of a measuring site for the air temperature in the cabinet.

The invention relates, in a further aspect, to a cabinet adapted for the accommodation of electrical and electronic devices, which cabinet comprises a cooling system of the invention. The cabinet can be an equipment cabinet adapted for being set up outdoors or indoors, more particularly, for server farms. Such equipment cabinets are also called enclosures, shelters, or racks. These cabinets are further used, for example, as electronics cabinets in railroad systems, for telecommunication facilities, and for environmental devices, traffic-controlling devices, process measurement devices, monitoring devices, and control devices.

Basically, the cabinet can be substantially airtight. In this case, an internal air circuit is provided in the cabinet for cooling the electrical and/or electronic devices present therein.

Preferably, however, heated air is blown out to one side of the cabinet. A so-called hot aisle can be formed on this side. In both situations, according to the invention, the temperature of the heated cooling fluid in the outflow duct is used as control variable.

In a further embodiment of the cabinet of the invention, a supplier for feeding in chilled cooling fluid into the inflow duct is provided. Furthermore, provision may be made for recirculation of the heated cooling fluid downstream of the valve of the invention.

Additional advantages and features of the invention are described below with reference to the attached diagrammatical figures, in which:
- Fig. 1: is a diagrammatical illustration of a cabinet of the invention for the accommodation of electrical and electronic devices and
- Fig. 2: is a diagrammatical illustration of an exemplary embodiment of a control system of the invention.

Like components are designated by like reference numerals in the two figures.

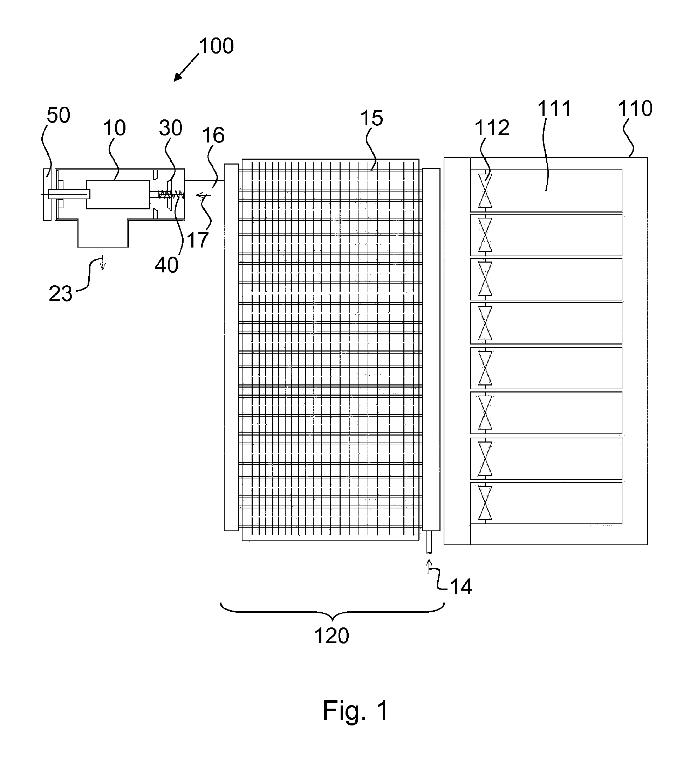

Fig. 1 is a diagrammatical illustration of an exemplary embodiment of a cabinet of the invention for the accommodation of electrical and electronic devices. The drawing serves the purpose of illustration and is not drawn to scale. The cabinet comprises a rack housing 110 and a cooling unit 120. Electrical and electronic devices to be cooled, for example servers, are accommodated in the rack housing 110. Fans 112 are provided on the servers 111 for the purpose of removing the air heated by the servers 111.

In an application serving as an example, a plurality of cabinets of the invention is arranged in rows. A cold aisle is formed on one side of the cabinet to which cooled air is fed. This air is caused to enter the cabinets and used for the purpose of cooling the electrical and electronic devices present in the cabinet. The air heated hereby is discharged into a hot aisle on the opposite side of the cabinet. The cooling unit 120 of the invention can be used to ensure that the temperature of the air discharged into the hot aisle is not unduly high. The cooling unit 120 is disposed on or in the rack housing 110 and it comprises an air/fluid heat exchanger 15, which, in the exemplary embodiment shown, is a heat exchanger for air/water, that is to say, water is used in this case as the cooling fluid 11. The cooling fluid 11 is passed through an inflow duct 14, which can also be referred to as the cooling water supply, to the heat exchanger 15. The air heated by the servers 111 is cooled by the cooling fluid 11 in the heat exchanger 15.

The cooling fluid 11 heated thereby leaves the heat exchanger 15 through an outflow duct 16. The outflow duct can also be referred to as the cooling water return duct 16. The outflow duct 16 passes the heated cooling fluid 11 to a valve 100 of the invention.

The valve 100 controls the rate of flow of the cooling fluid 11. For this purpose, the valve 100 increases the rate of flow as the temperature of the cooling fluid present in the valve 100 rises. The temperature of the cooling fluid 11 downstream of the heat exchanger 15 is a satisfactory measure of the temperature of the heated air or of the servers 111 to be cooled. Thus advantageously, the rate of flow of the cooling fluid 11 can be matched to the temperature of the heated air or the servers 111 without making it necessary to use temperature sensors on the servers 111 themselves for this purpose.

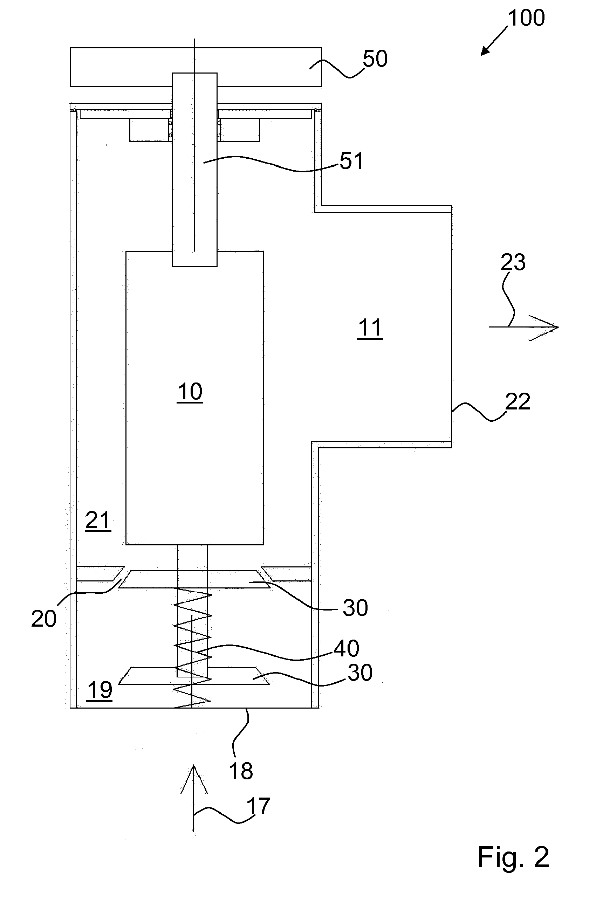

A preferred setup of the control system 100 of the invention is described with reference to Fig. 2. The cooling fluid 11 flows in the direction of the arrow 17 through an inlet 18 of the valve of the control system 100. It flows through a valve gap 20 and leaves the valve through an outlet 22 in the direction of the arrow 23.

In order to control the rate of flow of the cooling fluid 11 through the valve gap 20, there is provided a shut-off member 30 in the form of a valve cone. Fig. 2 shows the shut-off member in its closed position, in which it closes the valve gap 20 to the point that scarcely any cooling fluid 11 can pass therethrough, and in an open position, in which the flow of the cooling fluid 11 through the valve gap 20 is substantially unobstructed by the shut-off member 30.

A temperature-dependent opening of the valve gap 20 is effected by an actuator 10, which actuator is formed, in the example shown, by an expansible element 10 which is operatively linked to the shut-off member 30.

The expansible element 10 is disposed in a region through which cooling fluid flows such that its temperature assumes the same value as that of the cooling fluid 11. When the temperature of the cooling fluid 11 flowing through said region rises, the temperature of the expansible element 10 increases, resulting in expansion thereof. Thus, the expansion via a housing of the expansible element is converted at least for the most part into a change in length in a direction towards the shut-off member 30. As a result, the expansible element 10 presses with increasing force against the shut-off member 30 as its temperature rises. The shut-off member 30 thus opens the valve gap 20 to a greater extent, so that the rate of flow of the cooling fluid 11 increases.

When the temperature of the cooling fluid 11 drops, the expansible element 10 contracts and moves the shut-off member 30 back toward the valve gap 20. Thus the rate of flow is reduced in proportion to the temperature drops.

The change in length of the expansible element 10 is proportionally or continuously, more particularly linearly, dependent on the temperature. Thus the rate of flow is also controlled proportionally or linearly by the temperature.

A spring 40 is provided in order to ensure that the shut-off member 30 also returns when the expansible element 10 contracts. The spring 40 is disposed in a region 19 upstream of the valve gap 20 while the expansible element 10 is disposed in a region 21 downstream of the valve gap 20. The spring 40 presses the shut-off member 30 in the direction of flow of the cooling fluid 11 toward the valve gap 20.

The valve of the control system 100 further comprises an adjusting device 50 for the purpose of adjusting the rate of flow. The adjusting device 50 is accessible to a user from the outside. The adjusting device 50 comprises a screw-threaded rod 51 connected to the expansible element 10. Thus the user can vary the position of the expansible element 10 by means of the adjusting device 50.

If the expansible element 10 is permanently connected to the shut-off member 30, as in the case illustrated, the position of the shut-off member 30 relative to the valve gap 20, and thus the rate of flow, is altered directly by means of the adjusting device 50.

Alternatively, an expansible element 10 may be provided that is not connected permanently to the shut-off member 30. In this case, the distance between the expansible element 10 and the shut-off member 30 is adjusted by means of the adjusting device 50. This distance represents the change in length of the expansible element 10 required for initiating the process of opening the valve gap 20 by way of the expansible element 10.

The user can control the temperature of the heated cooling fluid 11 due to the ability to adjust the rate of flow. As a result, the user can also specify a desired temperature of the servers 111 to be cooled or of the air heated by the servers 111.

Advantageously, there is no need for a temperature sensor and an actuator disposed remotely therefrom in the exemplary embodiment described above. Rather, their function is assumed by a single expansible element 10. Advantageously, it is thus possible for the valve to operate without any auxiliary energy supply.

The variable governing the control system is the temperature of the cooling fluid as heated by the air in the equipment cabinet or the temperature of the air removed from the equipment cabinet, and not the temperature of the air existing in the equipment cabinet itself. It is thus possible to dispense with the expensive and error-prone process of mounting temperature sensors on the electrical and electronic devices 111 to be cooled. Advantageously, no expensive electronic control systems are required, and a cost-effective and at the same time reliable setup is provided.

## Claims

1. A control system for controlling the cooling performance of a cooling system in a cabinet adapted for the accommodation of electrical and electronic devices, wherein said cooling system comprises
- an air/fluid heat exchanger (15) for cooling the air heated in the cabinet by said electrical and/or electronic devices,
- an inflow duct (14) for routing a cooling fluid (11) to the air/fluid heat exchanger (15),
- a return duct (16) for routing heated cooling fluid (11) away from said air/fluid heat exchanger (15), and
- a flow restrictor for adjusting the rate of flow of said cooling fluid (11), wherein said control system comprises a control and evaluation system for the purpose of adjusting said flow restrictor,
**characterized in that**
- a temperature detector for detecting the temperature of the cooling fluid (11) is provided in said outflow duct (16) and
- said control and evaluation system is adapted to adjust said flow restrictor in accordance with the temperature of the cooling fluid (11) as detected by said temperature detector, for the purpose of controlling the rate of flow of said cooling fluid (11).

2. The control system as defined in claim 1,
**characterized in that**
said flow restrictor is disposed in or on said inflow duct (14).

3. The control system as defined in claim 1,
**characterized in that**
said flow restrictor is disposed in or on said return duct (16).

4. The control system as defined in claim 3,
**characterized in that**
said temperature detector is formed at least partially by said flow restrictor.

5. The control system as defined in any one of claims 1 to 4,
**characterized in that**
said control system operates without the use of auxiliary energy.

6. The control system as defined in claim 1, 3, 4 or 5,
**characterized in that**
said temperature detector, said flow restrictor, and said control/evaluation system are formed at least partially by a valve for effecting temperature-dependent control of a flow of cooling fluid, which valve comprises
- a valve gap (20) for enabling the flow of cooling fluid,
- a shut-off member (30), the position of which adjusts the flow of fluid through said valve-gap (20), and
- an actuator (10) adapted to control the position of said shut-off member (30),
wherein said actuator (10) exhibits a thermally induced change in length for the purpose of controlling the position of said shut-off member (30), and said actuator (10) is disposed in a region in which it is at least partially surrounded by cooling fluid as it flows therethrough.

7. The control system as defined in claim 6,
**characterized in that**
said actuator (10) is an expansible element (10).

8. The control system as defined in claim 6 or claim 7,
**characterized in that**
the change in length of said actuator (10) results in a continuous change in the position of said shut-off member (30).

9. The control system as defined in any one of claims 6 to 8,
**characterized in that**
an adjusting device (50), more particularly one comprising a screw-threaded rod (51), is provided for the purpose of adjusting a position of said shut-off member (30).

10. The control system as defined in any one of claims 6 to 9,
**characterized in that**
said valve-gap (20) is substantially obstructed in a closed position of said shut-off member (30) and is unobstructed in an open position thereof and
said actuator (10) is configured such that a change in length of said actuator (10), by means of which said shut-off member (30) is moved between its closed position and its open position, will take place within a temperature range which is less than 10°C, preferably less than 6°C, and more preferably less than 3°C.

11. The control system as defined in any one of claims 6 to 10,
**characterized in that**
the change in length of said actuator (10) is, at least over a certain temperature range, substantially linearly temperature-dependent.

12. The control system as defined in any one of claims 6 to 11,
**characterized in that**
said actuator (10) is disposed downstream of said valve-gap (20).

13. A cooling system for a cabinet adapted for the accommodation of electrical and electronic devices, comprising
- a cooling unit, which comprises
- an air/fluid heat exchanger (15) for cooling the air heated in said cabinet by said electrical and/or electronic devices,
- an inflow duct (14) for routing a cooling fluid (11) to said air/fluid heat exchanger (15),
- an outflow duct (16) for routing heated cooling fluid (11) away from said air/fluid heat exchanger (15), and
- a flow restrictor for adjusting a rate of flow of the cooling fluid (11),
**characterized by**
a control system as defined in any one of claims 1 to 12.

14. A cabinet adapted for the accommodation of electrical and electronic devices,
**characterized by**
a cooling system as defined in claim 13.

15. The cabinet as defined in claim 14,
**characterized in that**
a supplier is provided for the purpose of supplying chilled cooling fluid (11) to said inflow duct (14).
